# EUROPEAN PATENT SPECIFICATION

(11) **EP 2 676 829 B1**
(45) Date of publication and mention of the grant of the patent: **10.08.2016**
(21) Application number: 12172613.7
(22) Date of filing: 19.06.2012
(51) Int. Cl.: B60K 37/02, H05K 1/18, H05K 1/02, H05K 1/14, H05K 3/46

(54) **Carrier assembly for an instrument cluster**
Trägeranordnung für ein Instrumentenbündel
Ensemble support pour groupe d'instruments

(43) Date of publication of application: 25.12.2013
(73) Proprietor: Johnson Controls Automotive Electronics SAS, 95892 Cergy-Pontoise Cedex (FR)
(72) Inventor: Yankulov, Yordan Spasov, 2040 Dolna banya (BG); Macquet, Eric, 95320 Saint Leu la Forêt (FR); Scuri, Olivier, 95640 Haravillier (FR); Marty, Sylvain, 78124 Mareil sur Mauldre (FR); Leger, Nicolas, 95240 Cormeilles-en-Parisis (FR)
(74) Representative: Liedtke, Markus

(56) References cited:
- EP-A2- 0 645 276
- DE-A1- 19 941 352
- DE-A1-102004 005 479
- US-A- 5 495 076

## Description

The invention relates to a carrier assembly for carrying an instrument cluster. Furthermore the invention relates to a use of such a carrier assembly and to a method for assembling it.

In this application the term instrument cluster is used in general for a group of instruments. In the context of a vehicle it is used in particular for a group of instruments (gauges) placed on the dashboard of the vehicle. Instruments of an instrument cluster are often supported by printed circuit boards. WO 2006/097371 A1 discloses a printed circuit board comprising at least three rigid regions and at least two flexible regions which are thinner than the rigid regions. A first rigid region is coupled to the second rigid region by means of a first flexible region and the second rigid region is coupled to the third rigid region by means of a second flexible region.

Generic EP 0 645 276 A2 discloses a combination instrument with a housing, a system carrier for accommodating display instruments and a printed circuit board which is connected to the system carrier.

DE 199 41 352 A1 discloses a combination instrument having a base body which is split into display areas oriented at different angles relative to one another. An additional printed circuit extending over a plurality of display areas is arranged on the front of the base body. This additional printed circuit comprises rigid printed circuit parts which have flexible connecting regions with conductor tracks in the junction region of the display areas.

It is an object of the present invention to provide an improved carrier assembly for carrying an instrument cluster and to provide a method for assembling such a carrier assembly. It is a further object of the invention to provide an improved dashboard of a vehicle.

These objects are achieved by a carrier assembly according to claim 1, a method according to claim 7 and a use of a carrier assembly according to claim 8.

Preferred embodiments of the invention are given in the dependent claims.

A carrier assembly for carrying an instrument cluster according to the invention comprises a housing for the instrument cluster, said housing having a front side to expose instruments of the instrument cluster and a back side opposite to the front side. The housing consists of several housing portions arranged side by side, with every two adjacent housing portions linked flexibly to one another by at least one hinge. The carrier assembly further comprises for each of said housing portions a printed circuit board fixed to the back side of the housing portion, with every two adjacent printed circuit boards linked flexibly by at least one flexible printed circuit. The hinges and the flexible printed circuits are designed in such a way that every two adjacent housing portions are tiltable with respect to each other around a tilt axis.

A carrier assembly according to the invention thus can be shaped by tilting housing portions with respect to each other. This is advantageous, in particular, for building a dashboard with instruments which are placed at angles to each other, adapting the angles as needed. By linking a printed circuit board to each housing portion and connecting the printed circuit boards flexibly to one another by flexible printed circuits, the instruments can be supported electrically in the same way as in the case of a standard carrier assembly.

In a preferred embodiment of the invention the hinges and the flexible printed circuits are designed such that they allow to arrange all printed circuit boards in a common plane.

This embodiment of the invention simplifies both the manufacturing and the design of the carrier assembly. The manufacturing is simplified because the housing of the carrier assembly can be molded as a plane workpiece. The design of an angled carrier assembly can be simplied because for each of the various housing portions one can use the same way of connecting the instruments to a standard printed circuit board as in the case of a plane carrier assembly owing to the flexible linkage of a printed circuit board to each housing portion.

In a particularly preferred embodiment of the invention the housing comprises at least one light channel to guide light to the front side of the housing.

This embodiment allows one to use the housing for guiding light for various indicators; in particular for a dashboard of vehicle, such as a gearshift position indicator, a seat belt warning light, a parking-brake-engagement warning light, an engine-malfunction light, a low fuel light, a low oil pressure light and/or a low tire pressure light: Furthermore; as the housing portions are tiltable with respect to each other, for every housing portion one may use the same light path as in the case of a single plane carrier assembly, i.e., it is not necessary to perfom a new calculation of light paths adapted to the geometrv of the carrier assembly but one can use knowledge for standard carrier assemblies.
printed circuit boards may be fixed to the back side of housing portions by means of clip connections and/or screw connections and/or by sandwiching a printed circuit board between the housing portion and a back cover fixed to the housing portion.

The housing may be made at least partly of acrylonitrile butadiene styrene and/or a polycarbonate.

A method to assemble a carrier assembly according to the invention comprises three successive steps. In a first step the printed circuit boards are linked by the flexible printed circuits. In a second step at least part of the instrument cluster is mounted to the carrier assembly and the printed circuit boards are fixed to the back sides of the housing portions while the printed circuit boards are arranged in a common plane. In third step the housing portions are tilted with respect to each other.

Assembling a carrier assembly according to the invention in this way is advantageous because the printed circuit boards and instruments of the instrument cluster are assembled in a plane state of the carrier assembly which is easier than assembling them in a bended state. Furthermore, it is also easier to calibrate instruments in a plane state of the carrier assembly than in a bended state.

A carrier assembly according to the invention can, in particular, advantageously be used as part of a dashboard of a vehicle for carrying dashboard instruments.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### Brief Description of the Drawings

The present invention will become more fully understood from the detailed description given hereinbelow and the accompanying drawings which are given by way of illustration only, and thus, do not limit the present invention, wherein:
- Figure 1: shows a perspective exploded view of a carrier assembly comprising a housing for an instrument cluster and printed circuit boards, as well as part of the instrument cluster prior to assembling the carrier assembly,
- Figure 2: shows a side view of the carrier assembly with the PBCs fixed to the housing and arranged in common plane, with part of the instrument cluster mounted to the carrier assembly,
- Figure 3: shows the back side of the carrier assembly in the state shown in figure 2,
- Figure 4: shows the front side of the carrier assembly in the state shown in figures 2 and 3,
- Figure 5: shows a side view of the carrier assembly with the PBCs fixed to housing portions tilted with respect to each other, with part of the instrument cluster mounted to the carrier assembly,
- Figure 6: shows a perspective view from the back side of the carrier assembly in the state shown in figure 5, and
- Figure 7: shows a perspective view from the front side of the carrier assembly in the state shown in figure 5.

Corresponding parts are marked with the same reference symbols in all figures.

### Detailed Description of Preferred Embodiments

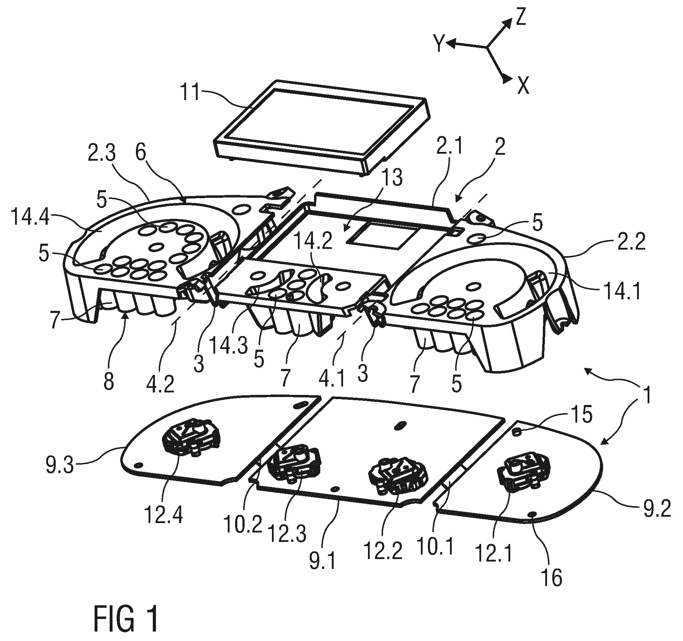

Figure 1 shows a perspective exploded view of a carrier assembly 1 for carrying an instrument cluster prior to assembling the carrier assembly 1. The carrier assembly 1 is designed to be used as part of a dashboard of a vehicle. Accordingly the instrument cluster contains dashboard instruments of the dashboard.

The carrier assembly 1 comprises a housing 2 for the instrument cluster. The housing consists of three housing portions 2.1, 2.2, 2.3 arranged side by side in a row, with a first housing portion 2.1 being arranged centrally between a second housing portion 2.2 and the third housing portion 2.3.

The first housing portion 2.1 is linked flexibly at one side to the second housing portion 2.2 by two hinges 3 and at the opposite side to the third housing portion 2.3 by two additional hinges 3 in such a way that the second housing portion 2.2 is tiltable with respect to the first housing portion 2.1 around a first tilt axis 4.1 and the third housing portion 2.3 is tiltable with respect to the first housing portion 2.1 around a second tilt axis 4.2 running parallel to the first tilt axis.

All three housing portions 2.1, 2.2, 2.3 comprise several light channels 5 to guide light to a front side 6 of the housing 2, the light channels 5 being formed by light tubes 7 extending from the front side 6 to a rear side 8 of the housing 2, respectively. The light channels 5 may be used for indicators such as gearshift position indicator, seat belt warning light, parking-brake-engagement warning light, an engine-malfunction light, low fuel light, low oil pressure light and/or low tire pressure light.

The carrier assembly 1 further comprises for each housing portion 2.1, 2.2, 2.3 a corresponding printed circuit board 9.1, 9.2, 9.3 to be fixed to the back side 8 of the housing portion 2.1, 2.2, 2.3. A first printed circuit board 9.1 corresponding to the first housing portion 2.1 is arranged centrally between a second printed circuit board 9.2 and a third printed circuit board 9.3 corresponding to the second housing portion 2.2 and third housing portion 2.3, respectively. The first printed circuit board 9.1 is flexibly linked at one side to the second printed circuit board 9.2 by a first flexible printed circuit 10.1 and at the opposite side to the third printed circuit board 9.3 by a second flexible printed circuit 10.2. The flexible printed circuits 10.1 and 10.2 are arranged in such a way that the housing portions 2.1, 2.2, 2.3 are still tiltable with respect to each other around the tilt axes 4.1, 4.2 after the printed circuit boards 9.1, 9.2, 9.3 have been fixed to the housing portions 2.1, 2.2, 2.3.

Figure 1 also shows part of the instrument cluster comprising a central display unit 11 and four pointer units 12.1, 12.2, 12.3, 12.4. The display unit 11 is mountable in a corresponding display recess 13 of the first housing portion 2.1. A first pointer unit 12.1 is mounted to the second printed circuit board 9.2, a second pointer unit 12.2 and a third pointer unit 12.3 are mounted to the first printed circuit board 9.1 and the fourth pointer unit 12.4 is mounted to third printed circuit board 9.3. The housing 2 comprises for each pointer unit 12.1, 12.2, 12.3, 12.4 a corresponding pointer recess 14.1, 14.2, 14.3, 14.4. Each pointer unit 12.1, 12.2, 12.3, 12.4 comprises a pointer element which is movable in the corresponding pointer recess 14.1, 14.2, 14.3, 14.4. In addition each pointer unit 12.1, 12.2, 12.3, 12.4 comprises a pointer drive to drive the respective pointer element. For instance, the pointer units 12.1, 12.2, 12.3, 12.4 may provide pointers for a tachometer, speedometer, odometer and/or fuel gauge.

Each printed circuit board 9.1, 9.2, 9.3 has one oblong hole 15 and one standard hole 16 which may be used to fix the printed circuit boards 9.1, 9.2, 9.3 to the corresponding housing portion 2.1, 2.2, 2.3 by means of screw connections.

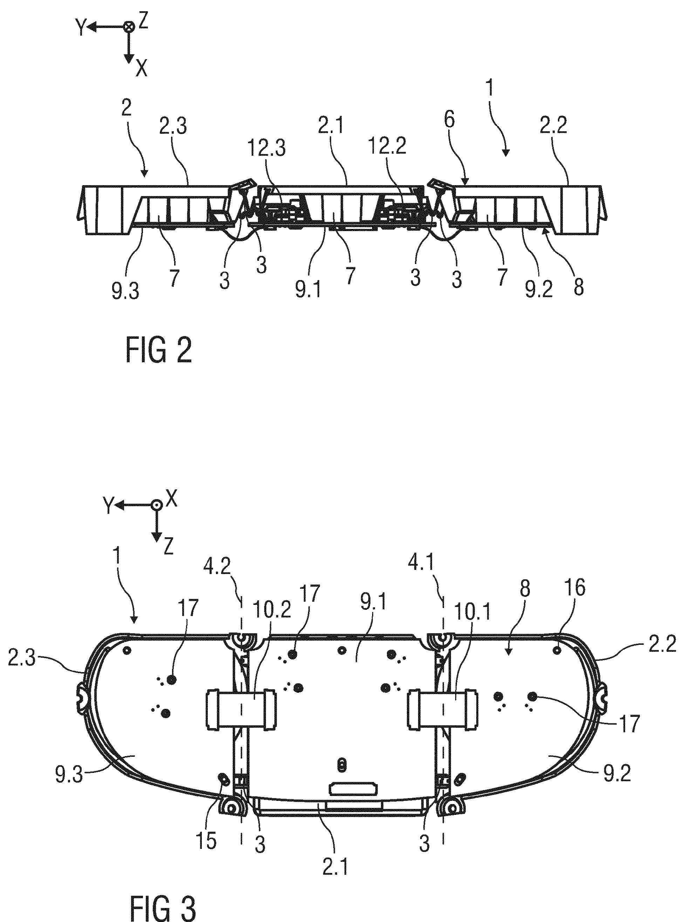

**Figures 2 to 4** show, respectively, a side view, a view of the back side and a view of the front side of the carrier assembly 1 with the printed circuit boards 9.1, 9.2, 9.3 fixed to the housing 2 and arranged in common plane and with the display unit 11 and the pointer units 12.1, 12.2, 12.3, 12.4 mounted to the carrier assembly 1. Figure 3 also shows in part clip connections 17 by means of which the pointer units 12.1, 12.2, 12.3, 12.4 are mounted to the printed circuit boards 9.1, 9.2, 9.3.

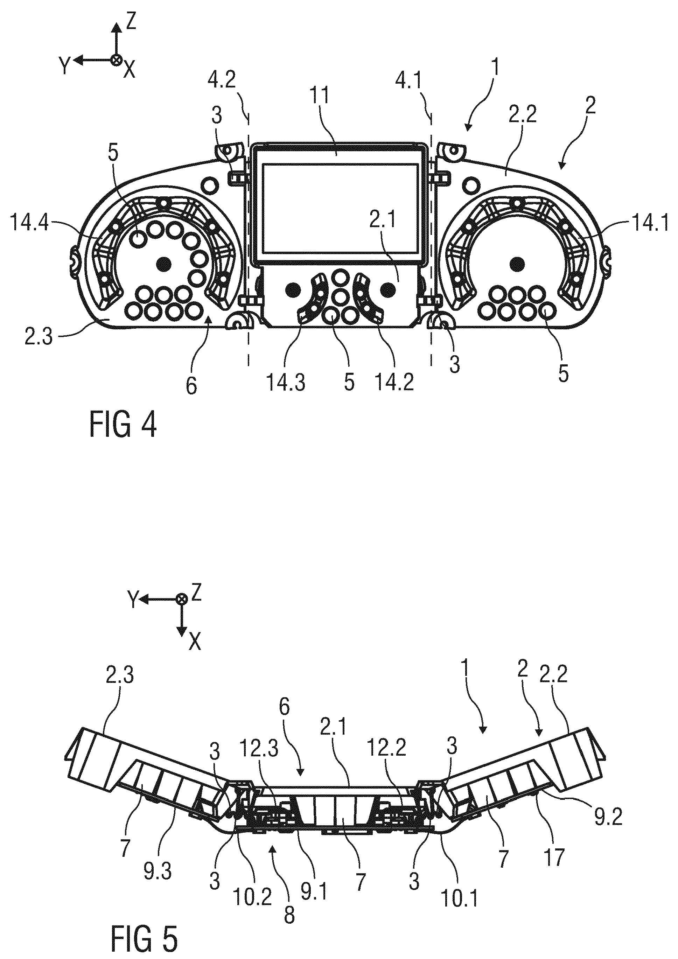

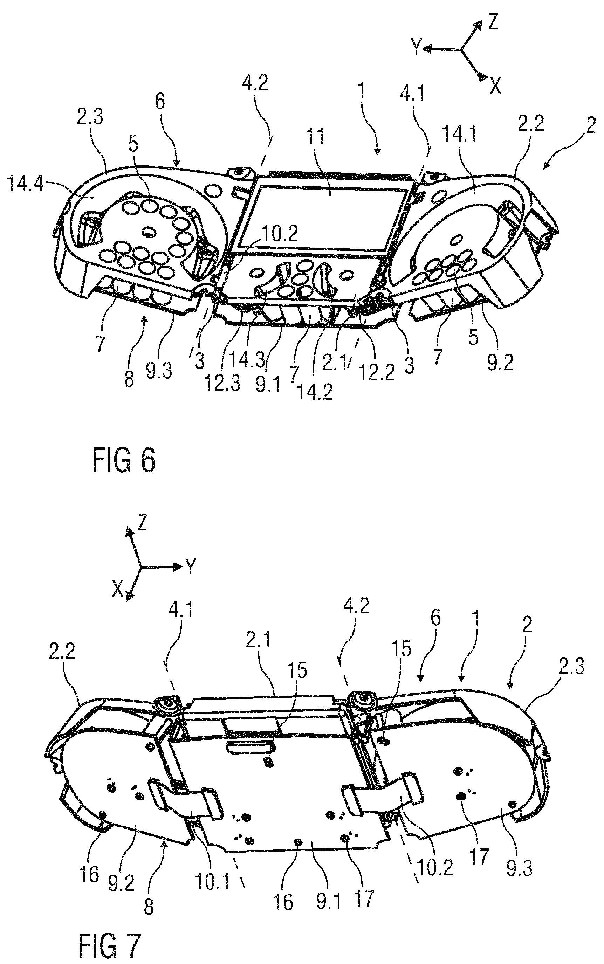

**Figures 5 to 7** show, respectively, a side view, a perspective view from the back side and a perspective view from the front side of the carrier assembly 1 with the printed circuit boards 9.1, 9.2, 9.3 fixed to the housing portions 2.1, 2.2, 2.3 and the latter tilted with respect to each other. Again, the display unit 11 and the pointer units 12.1, 12.2, 12.3, 12.4 have been mounted to the carrier assembly 1 already.

The figures may also be used to explain how the carrier assembly 1 is assembled according to the invention. In a first step the printed circuit boards 9.1, 9.2, 9.3 are linked by the flexible printed circuits 10.1, 10.2. In a second step the display unit 11 and the pointer units 12.1, 12.2, 12.3, 12.4 are mounted to the carrier assembly 1 and the printed circuit boards 9.1, 9.2, 9.3 are fixed to the back sides of the housing portions 2.1, 2.2, 2.3 while the printed circuit boards 9.1, 9.2, 9.3 are arranged in a common plane. The result of the second step is shown in figures 2 to 4. In a third step the second housing portion 2.2 and the third housing portion 2.3 are tilted with respect to the first housing portion 2.1. The result of the third step is shown in figures 5 to 7 and exhibits the final state of the carrier assembly 1.

### List of References

- 1: carrier assembly
- 2: housing
- 2.1, 2.2, 2.3: housing portion
- 3: hinge
- 4.1, 4.2: tilt axis
- 5: light channel
- 6: front side
- 7: light tube
- 8: rear side
- 9.1, 9.2, 9.3: printed circuit board
- 10.1, 10.2: flexible printed circuit
- 11: display unit
- 12.1, 12.2, 12.3, 12.4: pointer unit
- 13: display recess
- 14.1, 14.2, 14.3, 14.4: pointer recess
- 15: oblong hole
- 16: standard hole
- 17: clip connection

## Claims

1. Carrier assembly (1) for carrying an instrument cluster, the carrier assembly (1) comprising a housing (2) for the instrument cluster, said housing (2) having a front side (6) to expose instruments of the instrument cluster and a back side (8) opposite to the front side (6), and said housing (2) consisting of several housing portions (2.1, 2.2, 2.3) arranged side by side, with every two adjacent housing portions (2.1, 2.2, 2.3) linked flexibly to one another by at least one hinge (3), the carrier assembly (1) further comprising for each of said housing portions (2.1, 2.2, 2.3) a printed circuit board (9.1, 9.2, 9.3) fixed to the back side of the housing portion (2.1, 2.2, 2.3), wherein the housing (2) comprises at least one light channel (5) to guide light to the front side (6) of the housing (2) **characterized in that** every two adjacent printed circuit boards (9.1, 9.2, 9.3) are linked flexibly by at least one flexible printed circuit (10.1, 10.2), whereby the hinges (3) and the flexible printed circuits (10.1, 10.2) are designed in such a way that every two adjacent housing portions (2.1, 2.2, 2.3) are tiltable with respect to each other around a tilt axis (4.1, 4.2).

2. Carrier assembly (1) according to claim 1,
**characterized in that** the hinges (3) and the flexible printed circuits (10.1, 10.2) are designed such that they allow to arrange all printed circuit boards (9.1, 9.2, 9.3) in a common plane.

3. Carrier assembly (1) according to any of the preceding claims,
**characterized by** clip connections for fixing printed circuit boards (9.1, 9.2, 9.3) to the back side (8) of housing portions (2.1, 2.2, 2.3).

4. Carrier assembly (1) according to any of the preceding claims, **characterized by** screw connections for fixing printed circuit boards (9.1, 9.2, 9.3) to the back side (8) of housing portions (2.1, 2.2, 2.3).

5. Carrier assembly (1) according to any of the preceding claims, **characterized in that** at least one printed circuit board (9.1, 9.2, 9.3) is fixed to the back side (8) of a housing portion (2.1, 2.2, 2.3) by sandwiching the printed circuit board (9.1, 9.2, 9.3) between the housing portion (2.1, 2.2, 2.3) and a back cover fixed to the housing portion (2.1, 2.2, 2.3).

6. Carrier assembly (1) according to any of the preceding claims, **characterized in that** the housing (2) is at least partly made of acrylonitrile butadiene styrene and/or an polycarbonate.

7. Method for assembling a carrier assembly (1) according to any of the preceding claims, the method comprising three successive steps, wherein in a first step the printed circuit boards (9.1, 9.2, 9.3) are linked by the flexible printed circuits (10.1, 10.2), in a second step at least part of the instrument cluster is mounted to the carrier assembly (1) and the printed circuit boards (9.1, 9.2, 9.3) are fixed to the back sides of the housing portions (2.1, 2.2, 2.3) while the printed circuit boards (9.1, 9.2, 9.3) are arranged in a common plane, and in a third step the housing portions (2.1, 2.2, 2.3) are tilted with respect to each other.

8. Use of a carrier assembly (1) according to any of the claims 1 to 6 as part of a dashboard of a vehicle for carrying dashboard instruments.

## Patentansprüche

1. Trägeranordnung (1) zum Tragen eines Kombi-Instruments, wobei die Trägeranordnung (1) ein Gehäuse (2) für das Kombi-Instrument umfasst, wobei das Gehäuse (2) eine Vorderseite (6), um Instrumente des Kombi-Instruments zu zeigen, und eine Rückseite (8), die der Vorderseite (6) gegenüberliegt, besitzt und das Gehäuse (2) aus mehreren Gehäuseabschnitten (2.1, 2.2, 2.3), die nebeneinander angeordnet sind, besteht, wobei alle paarweise benachbarten Gehäuseabschnitte (2.1, 2.2, 2.3) durch mindestens ein Gelenk (3) miteinander flexibel verbunden sind, wobei die Trägeranordnung (1) ferner für jeden Gehäuseabschnitt (2.1, 2.2, 2.3) eine Leiterplatte (9.1, 9.2, 9.3), die an der Rückseite des Gehäuseabschnitts (2.1, 2.2, 2.3) fixiert ist, umfasst,
wobei das Gehäuse (2) mindestens einen Lichtkanal (5), um Licht zu der Vorderseite (6) des Gehäuses (2) zu leiten, umfasst,
**dadurch gekennzeichnet, dass** alle paarweise benachbarten Leiterplatten (9.1, 9.2, 9.3) durch mindestens eine flexible gedruckte Schaltung (10.1, 10.2) flexibel verbunden sind, wobei die Gelenke (3) und die flexiblen gedruckten Schaltungen (10.1, 10.2) so entworfen sind, dass alle paarweise benachbarten Gehäuseabschnitte (2.1, 2.2, 2.3) relativ zueinander um eine Neigungsachse (4.1, 4.2) geneigt werden können.

2. Trägeranordnung (1) nach Anspruch 1,
**dadurch gekennzeichnet, dass** die Gelenke (3) und die flexiblen gedruckten Schaltungen (10.1, 10.2) so entworfen sind, dass sie ermöglichen, alle Leiterplatten (9.1, 9.2, 9.3) in einer gemeinsamen Ebene anzuordnen.

3. Trägeranordnung (1) nach einem der vorhergehenden Ansprüche,
**gekennzeichnet durch** Klammerverbindungen zum Fixieren von Leiterplatten (9.1, 9.2, 9.3) an der Rückseite (8) von Gehäuseabschnitten (2.1, 2.2, 2.3).

4. Trägeranordnung (1) nach einem der vorhergehenden Ansprüche,
**gekennzeichnet durch** Schraubverbindungen zum Fixieren von Leiterplatten (9.1, 9.2, 9.3) an der Rückseite (8) von Gehäuseabschnitten (2.1, 2.2, 2.3).

5. Trägeranordnung (1) nach einem der vorhergehenden Ansprüche,
**dadurch gekennzeichnet, dass** mindestens eine Leiterplatte (9.1, 9.2, 9.3) durch Einklemmen der Leiterplatte (9.1, 9.2, 9.3) zwischen dem Gehäuseabschnitt (2.1, 2.2, 2.3) und einer rückseitigen Abdeckung, die an dem Gehäuseabschnitt (2.1, 2.2, 2.3) fixiert ist, an der Rückseite (8) eines Gehäuseabschnitts (2.1, 2.2, 2.3) fixiert ist.

6. Trägeranordnung (1) nach einem der vorhergehenden Ansprüche,
**dadurch gekennzeichnet, dass** das Gehäuse (2) mindestens teilweise aus Acrylnitril-Butadien-Styrol und/oder einem Polycarbonat gebildet ist.

7. Verfahren zum Anordnen einer Trägeranordnung (1) nach einem der vorhergehenden Ansprüche, wobei das Verfahren drei aufeinanderfolgende Schritte umfasst,
wobei in einem ersten Schritt die Leiterplatten (9.1, 9.2, 9.3) durch die flexiblen gedruckten Schaltungen (10.1, 10.2) verbunden werden, in einem zweiten Schritt mindestens ein Teil des Kombi-Instruments an der Trägeranordnung (1) befestigt wird und die Leiterplatten (9.1, 9.2, 9.3) an den Rückseiten der Gehäuseabschnitte (2.1, 2.2, 2.3) fixiert werden, während die Leiterplatten (9.1, 9.2, 9.3) in einer gemeinsamen Ebene angeordnet werden, und in einem dritten Schritt die Gehäuseabschnitte (2.1, 2.2, 2.3) relativ zueinander geneigt werden.

8. Verwendung einer Trägeranordnung (1) gemäß einem der Ansprüche 1 bis 6 als Teil eines Armaturenbretts eines Fahrzeugs zum Tragen von Armaturenbrettinstrumenten.

## Revendications

1. Ensemble support (1) destiné à supporter un groupe d'instruments, l'ensemble support (1) comprenant un boîtier (2) pour le groupe d'instruments, ledit boîtier (2) ayant une face avant (6) pour exposer les instruments du groupe d'instruments et une face arrière (8), opposée à la face avant (6), et ledit boîtier (2) est constitué de plusieurs parties de boîtier (2.1, 2.2, 2.3) agencées côte à côte, avec chaque deux parties de boîtier adjacentes (2.1, 2.2, 2.3) étant reliées de manière flexible l'une à l'autre par au moins une charnière (3), l'ensemble support (1) comprenant en outre pour chacune desdites parties de boîtier (2.1, 2.2, 2.3), une carte de circuit imprimé (9.1, 9.2, 9.3) fixée sur la face arrière de la partie de boîtier (2.1, 2.2, 2.3),
où le boîtier (2) comprend au moins un canal lumineux (5) pour guider la lumière vers la face avant (6) du boîtier (2),
**caractérisé en ce que** chaque deux cartes de circuit imprimé (9.1, 9.2, 9.3) adjacentes sont reliées de manière flexible par au moins un circuit imprimé flexible (10.1, 10.2), les charnières (3) et les circuits imprimés flexibles (10.1, 10.2) étant conçus de manière à ce que chaque deux parties de boîtier (2.1, 2.2, 2.3) adjacentes soient inclinables l'une par rapport à l'autre autour d'un axe d'inclinaison (4.1, 4.2).

2. Ensemble support (1) selon la revendication 1, **caractérisé en ce que** les charnières (3) et les circuits imprimés flexibles (10.1, 10.2) sont conçus de manière à ce qu'ils permettent de disposer toutes les cartes de circuit imprimé (9.1, 9.2, 9.3) dans un plan commun.

3. Ensemble support (1) selon l'une quelconque des revendications précédentes,
**caractérisé par** des connexions par clip destinées à fixer des cartes de circuit imprimé (9.1, 9.2, 9.3) sur la face arrière (8) des parties de boîtier (2.1, 2.2, 2.3).

4. Ensemble support (1) selon l'une quelconque des revendications précédentes,
**caractérisé par** des connexions à vis destinées à fixer des cartes de circuit imprimé (9.1, 9.2, 9.3) sur la face arrière (8) des parties de boîtier (2.1, 2.2, 2.3).

5. Ensemble support (1) selon l'une quelconque des revendications précédentes, **caractérisé en ce qu'**au moins une carte de circuit imprimé (9.1, 9.2, 9.3) est fixée sur la face arrière (8) d'une partie de boîtier (2.1, 2.2, 2.3) par prenant en sandwich la carte de circuit imprimé (9.1, 9.2, 9.3) entre la partie de boîtier (2.1, 2.2, 2.3) et un couvercle arrière fixé à la partie de boîtier (2.1, 2.2, 2.3).

6. Ensemble support (1) selon l'une quelconque des revendications précédentes, **caractérisé en ce que** le boîtier (2) est au moins partiellement constitué d'acrylonitrile butadiène styrène et/ou de polycarbonate.

7. Procédé pour assembler un ensemble support (1) selon l'une quelconque des revendications précédentes, le procédé comprenant trois étapes successives, où, dans une première étape, les cartes de circuit imprimé (9.1, 9.2, 9.3) sont reliées par les circuits imprimés flexibles (10.1, 10.2), dans une deuxième étape, au moins une partie du groupe d'instruments est monté sur l'ensemble support (1) et les cartes de circuit imprimé (9.1, 9.2, 9.3) sont fixées aux faces arrière des parties de boîtier (2.1, 2.2, 2.3), tandis que les cartes de circuit imprimé (9.1, 9.2, 9.3) sont disposées dans un plan commun, et dans une troisième étape, les parties de boîtier (2.1, 2.2, 2.3) sont inclinées les unes par rapport aux autres.

8. Utilisation d'un ensemble support (1) selon l'une quelconque des revendications 1 à 6 comme partie d'un tableau de bord d'un véhicule destinée au support des instruments du tableau de bord.
